# EUROPEAN PATENT APPLICATION

(11) **EP 2 378 561 A1**
(43) Date of publication of application: **19.10.2011**
(21) Application number: 10729189.0
(22) Date of filing: 04.01.2010
(51) Int. Cl.: H01L 31/04

(54) **THIN-FILM SOLAR CELL MODULE AND THIN-FILM SOLAR CELL ARRAY**

(30) Priority: 09.01.2009 JP 2009003844
(71) Applicant: Sharp Kabushiki Kaisha, Osaka-shi, Osaka 545-8522 (JP)
(72) Inventor: NASUNO, Yoshiyuki, Osaka 545-8522 (JP); NAKANO, Takanori, Osaka 545-8522 (JP); SHIMIZU, Akira, Osaka 545-8522 (JP)
(74) Representative: Hoffmann, Jörg Peter
(86) International application number: PCT/JP2010/050005
(87) International publication number: WO 2010/079769

(57) **Abstract**

The thin-film solar cell module according to the present invention has a substrate and a cell module that includes three or more cell strings, each of which has a constant width, and is **characterized in that** each cell string has a plurality of solar cells which are connected in series, the cell strings are provided on the substrate so as to be aligned in a direction perpendicular to a direction in which the solar cells are connected in series and connected to each other in parallel, the solar cells each have a front surface electrode, a photoelectric conversion layer and a rear surface electrode stacked in this order, the cell strings have contact lines which electrically connect the front surface electrode of one of neighboring solar cells of the solar cells and the rear surface electrode of the other, the solar cells being included in the cell string, and have the same width as the cell string, and at least one of the cell strings at the two ends of the above described three or more cell strings has a width greater than the other cell strings.

## Description

### TECHNICAL FIELD

The present invention relates to a thin-film solar cell module and a thin-film solar cell array.

### BACKGROUND ART

In recent years, thin-film photoelectric conversion devices formed in accordance with a plasma CVD method using gases as materials have been receiving attention. Examples of such thin-film photoelectric conversion devices include silicon-based thin-film photoelectric conversion devices made of silicon-based thin-films and thin-film photoelectric conversion devices made of CIS (CuInSe₂) compounds and CIGS (Cu(In, Ga)Se₂) compounds, and the development of these has been accelerated and the quantity of their production has been increased. These photoelectric conversion devices are greatly characterized in that semiconductor layers or metal electrode films are layered on an inexpensive substrate having a large area using a plasma CVD apparatus, a sputtering apparatus and other film forming apparatuses, and then separated and connected through laser patterning or the like so as to provide a potential that photoelectric conversion devices having high performance can be fabricated at a low cost.

Incidentally, thin-film solar cell modules where cell strings formed of a plurality of solar cells connected in series are connected in parallel, as shown in FIG. 8, have been known (see, for example, Patent Document 1). When solar light does not hit part of the solar cells 203, which are part of the thin-film solar cell module 210, an output from the entirety of the thin-film solar cell module 210 greatly lowers, and in some cases the thus-lowered output does not recover. Examples are a case where a leaf or the like attaches to a top of part of the solar cells 203 and a case where part of the solar cells 203 are in a shade. It is considered that the output lowers due to a hot spot phenomenon when the solar light does not hit part of the solar cells 203. It is possible for this hot spot phenomenon to occur as follows. In the case where no solar light hits part of the solar cells 203, which are included in the cell string 202, photovoltaic power in the other solar cells 203 causes insulation breakdown in the solar cells 203 which are not hit by the solar light (which work as a diode for rectifying the current in a direction opposite to the current caused by the photovoltaic power), and thus heat is generated locally. It is possible for the thus-heated metal in the solar cells 203 to melt, and thus cause film peeling or other damage to the solar cells 203 to occur. Various types of research have been conducted in order to solve this problem of the output being lowered due to the hot spot phenomenon.

Patent Document 1, for example, describes that a solar cell module can be designed so that a short-circuiting current of 600 mA or less flows through each cell string under predetermined conditions, and thus the breakdown of a solar cell due to the hot spot phenomenon can be adequately prevented.

### PRIOR ART DOCUMENT

### PATENT DOCUMENT

Patent Document 1: Japanese Unexamined Patent Application Publication No. 2001-68713

### SUMMARY OF THE INVENTION

### PROBLEM TO BE SOLVED BY THE INVENTION

However, in the case where cell strings formed of a plurality of solar cells connected in series are connected in parallel in a thin-film solar cell module, even when the thin-film solar cell module is designed such that a short-circuiting current of 600 mA or less flows through a cell string, an output from the thin-film solar cell module greatly lowers, and in some cases the output does not recover when the solar light does not hit part of the thin-film solar cell module.
The present invention is provided in view of this circumstance and provides a thin-film solar cell module where the solar cells can be prevented from being damaged, even in the case where the solar light does not hit part of the thin-film solar cell module.

### MEANS FOR SOLVING PROBLEM

The thin-film solar cell module according to the present invention has a substrate and a cell module that includes three or more cell strings, each of which has a constant width, and is characterized in that each cell string has a plurality of solar cells which have the same width as the cell string and are connected in series, the cell strings are provided on the substrate so as to be aligned in a direction perpendicular to a direction in which the solar cells are connected in series and connected to each other in parallel, the solar cells each have a front surface electrode, a photoelectric conversion layer and a rear surface electrode stacked in this order, the cell strings have contact lines which electrically connect the front surface electrode of one of neighboring solar cells of the solar cells and the rear surface electrode of the other, the solar cells being included in the cell string, and have the same width as the cell string, and at least one of the cell strings at the two ends of the above described three or more cell strings has a width greater than the other cell strings.

The present inventors had conducted diligent research and found that the output in some cases lowers in the same manner as in the hot spot phenomenon when the majority of one or a few cell strings included in a thin-film solar cell module is in a shade. This is described in further detail below. When the majority of one or a few cell strings included in a thin-film solar cell module is in a shade, the photovoltaic power of this cell string lowers. As a result, the photovoltaic power generated by the other cell strings which are receiving light allows a current to flow in a direction opposite to a direction through which a current flows when the cell string in a shade is receiving light. It was found that this current damages the contact lines that connect the solar cells included in the cell string in series. This is considered to be because the photovoltaic power of the cell strings which are receiving light allows the density of the power applied to the cell string in a shade to be the greatest in the contact lines. It is believed that this damage causes an output from this cell string to lower, and thus an output from the thin-film solar cell module is lowered.

In many cases, such a cell string in a shade is a cell string at an end of the thin-film solar cell module. Examples are a case where an installed thin-film solar cell module is in the shade of a roof or another solar cell module and a case where snow accumulates on a thin-film solar cell module and melts but remains only in a lower portion of the solar cell module. Accordingly, the contact lines can be prevented from being damaged as described above in the cell strings at the ends, and thus the output from the thin-film solar cell module can be prevented from lowering.

The inventors had conducted further research and found that the above-described contact lines can be prevented from being damaged by making the width of the cell strings at the ends of a thin-film solar cell module greater than that of the other cell strings, and thus achieved the present invention.

### EFFECTS OF THE INVENTION

In the case where the width of the cell strings at the ends of a thin-film solar cell module is great, the light receiving area of the cell strings becomes great, and thus the probability of its entirety or majority being in a shade can be reduced. As a result, the contact lines can be prevented from being damaged.
In addition, the cross sectional area of the contact lines is great when the width of the cell strings is great. Thus, in the case where the entirety or majority of the cell string at an end of a thin-film solar cell module is in a shade, for example, a current flows in a direction opposite to a direction in which a current flows when the cell string receives light and a great cross sectional area of the contact lines can reduce the density of the power applied to the contact lines, and thus the contact lines can be prevented from being damaged.

### BRIEF DESCRIPTION OF THE DRAWINGS

FIG. 1 is a schematic plan diagram showing the structure of the thin-film solar cell module according to one embodiment of the present invention;
FIG. 2(a) is a schematic cross sectional diagram along chain line S-T in FIG. 1;
FIG. 2(b) is a schematic cross sectional diagram showing an enlargement of the portion B surrounded by a dotted line in FIG. 2(a);
FIG. 3(a) is a schematic plan diagram showing the portion A surrounded by a dotted line in FIG. 1;
FIG. 3(b) is a diagram showing the cross sectional area of a contact line;
FIGs. 4(a) to 4(c) are diagrams for illustrating a term "connection in parallel in a bidirectional manner;"
FIG. 5 is a schematic plan diagram showing the thin-film solar cell module according to one embodiment of the present invention;
FIG. 6 is a schematic cross sectional diagram showing the structure of a plasma CVD apparatus used for the manufacture of the thin-film solar cell module according to one embodiment of the present invention;
FIG. 7 is a schematic perspective diagram showing the thin-film solar cell array according to one embodiment of the present invention; and
FIG. 8 is a schematic plan diagram showing a conventional thin-film solar cell module.

### MODE FOR CARRYING OUT THE INVENTION

In the following, one embodiment of the present invention is described in reference to the drawings. The structures shown in the drawings and in the following description are illustrative, and the scope of the present invention is not limited to these structures.

### 1. Structure of Thin-Film Solar Cell Module

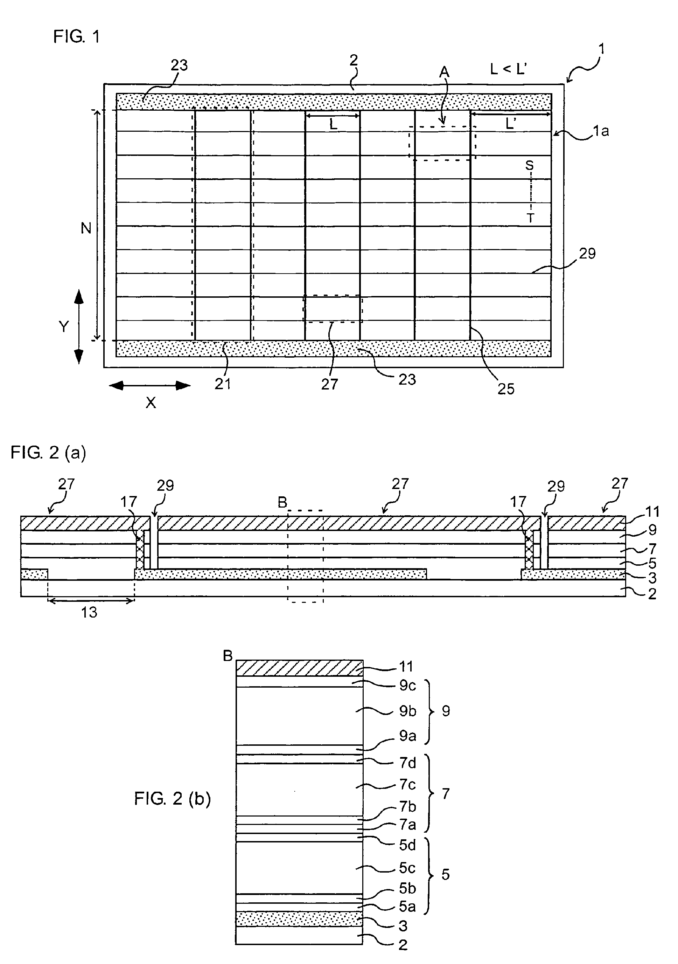

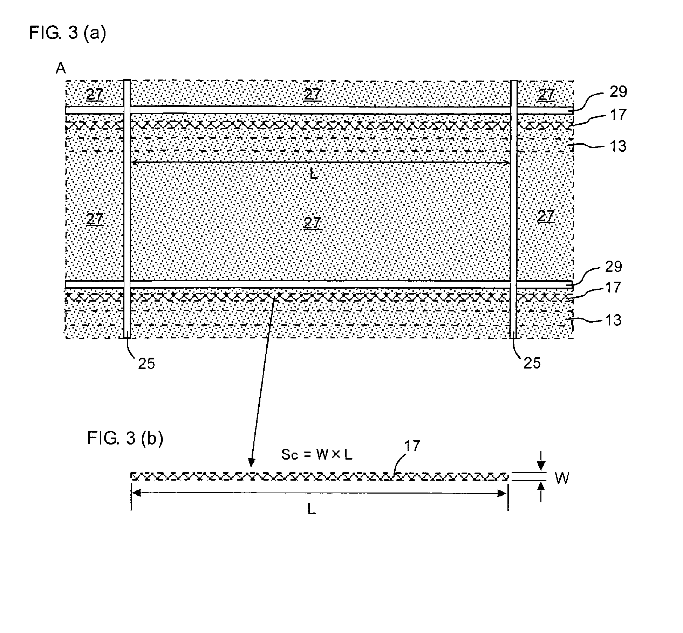

FIG. 1 is a schematic plan diagram showing the structure of the thin-film solar cell module according to one embodiment of the present invention. FIG. 2(a) is a schematic cross sectional diagram along the chain line S-T in FIG. 1, and FIG. 2(b) is a schematic cross sectional diagram showing an enlargement of the portion B surrounded by the dotted line in FIG. 2(a). In addition, FIG. 3(a) is a schematic plan diagram showing the portion A surrounded by the dotted line in FIG. 1, and FIG. 3(b) is a diagram for illustrating the cross sectional area of a contact line. Here, in FIG. 2(a), the front surface electrode dividing line 13 is wider than the contact line 17 and the rear surface electrode dividing line 29 so that the solar cells 27 can be seen as being connected in series.
Here, the thin-film solar cell modules shown in FIGs. 1 to 3 are thin-film solar cell modules having a superstrate type structure where the substrate side is a light receiving surface. However, the thin-film solar cell modules according to the present invention are not limited to those of a superstrate type structure, but may be thin-film solar cell modules having a substrate type structure where the substrate side is a rear surface. Here, in the case of a substrate type structure, a rear surface electrode, a photoelectric conversion layer and a front surface electrode are layered on a substrate in this order.

The thin-film solar cell module 1 according to the present embodiment has a substrate 2 and a cell module 1a that includes three or more cell strings 21, each of which has a constant width and is characterized in that each cell string 21 has a plurality of solar cells 27 which have the same width as that of the cell string 21 and are connected in series, the cell strings 21 are provided on the substrate 2 so as to be aligned in a direction perpendicular to a direction in which the solar cells 27 are connected in series and connected to each other in parallel, the solar cells 27 each have a front surface electrode 3, a photoelectric conversion layer (5, 7, 9) and a rear surface electrode 11 stacked in this order, the cell strings 21 have contact lines 21 which electrically connect the front surface electrode of one of neighboring solar cells of the solar cells and the rear surface electrode of the other, the solar cells 27 being included in the cell string 21, and have the same width as that of the cell string 21, and at least one of the cell strings 21 at the two ends of the three or more cell strings 21 has a width greater than that of the other cell strings 21.
In the following, the components of the thin-film solar cell module 1 according to the present invention are described.

### 1-1. Substrate

The substrate 2 is not particularly limited, but in the case of a superstrate type structure, for example, substrates having light transmitting properties, such as glass substrates having a resistance to heat in the plasma CVD film forming process, and resin substrates, such as of polyimide, can be used. In the case of a substrate structure, there are no particular limitations for the substrate.

### 1-2. Cell Module

There are no particular limitations in the cell module 1a as long as it includes three or more cell strings 21 that respectively have a constant width L, are bi-directionally connected to each other in parallel and are provided on the substrate 2 as to be aligned in the direction perpendicular to the direction in which the solar cells 27 are connected in series. In addition, a plurality of cell modules 1a may be formed on the same substrate.
Here, in the present invention, the lengthwise direction is the direction in which solar cells 27 are connected in series and the crosswise direction is the direction in which the cell strings 21 are aligned. In FIG. 1, for example, the direction Y is the lengthwise direction and the direction X is the crosswise direction.
The method according to which cell strings 21 are connected in parallel is not particularly limited, but they may be connected in parallel through common electrodes 23 that are connected to both ends of each cell string 21, for example. In addition, the common electrodes 23 include first common electrodes and second common electrodes, and the first common electrodes and the second common electrodes electrically connect the cell strings so that a current generated in the cell strings can flow into each other of the cell strings. In addition, the first common electrodes and the second common electrodes can be provided so that the two electrodes of the cell strings can be electrically connected to each other.
Here, the width of the cell strings 21 in the present invention is the length of the cell strings in the crosswise direction, and the width of the cell strings 21 is the length L of the cell strings 21 in the direction in which the cell strings 21 are aligned, for example, as in FIG. 1.

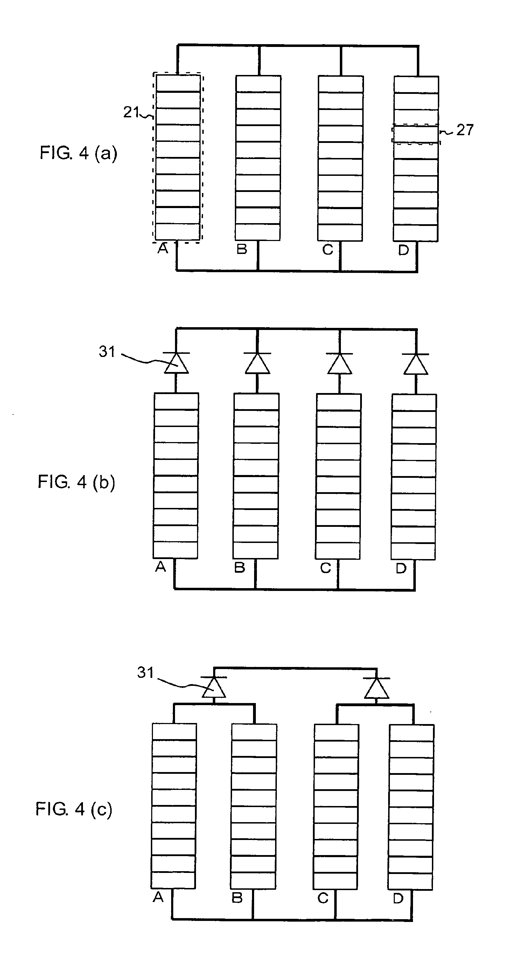

In addition, "connection in parallel in a bidirectional manner" in the present invention means such a state that a current generated in one cell string 21 can flow into the other cell string 21 and vice versa. FIGs. 4(a) to 4(c) are diagrams for illustrating the term "connection in parallel in a bidirectional manner." In the case where a plurality of cell strings 21 are connected in parallel without a blocking diode 31, as in FIG. 4(a), a current generated in the cell string A, for example, can flow into the cell string B, and a current generated in the cell string B can flow into the cell string A. Such a relationship exists between a combination of any two from among the cell strings A to D. Accordingly, the cell strings A to D are connected to each other in parallel in a bidirectional manner. Meanwhile, in the case where a plurality of cell strings 21 are connected in parallel via blocking diodes 31, as in FIG. 4(b), a current generated in the cell string A, for example, is blocked by the blocking diode 31 so as not to flow into the cell string B, and a current generated in the cell string B is blocked by the blocking diode 31 so as not to flow into the cell string A. Such a relationship exists between a combination of any two from among cell strings A to D. Accordingly, the cell strings A to D are not connected to each other in parallel in a bidirectional manner. In addition, the combination of the cell strings A and B and the combination of the cell strings C and D are respectively connected in parallel without a blocking diode 31, and these two combinations are connected in parallel via blocking diodes 31, as in FIG. 4(c). In this case, the cell strings A and B are connected to each other in parallel in a bidirectional manner and the cell strings C and D are connected to each other in parallel in a bidirectional manner. However, the cell strings A and C, for example, are not connected in parallel in a bidirectional manner.

The cell module 1a can provide an output of 90 W or more and 385 W or less under such conditions that the light source is a xenon lamp, irradiance is 100 mW/cm², AM (air mass) is 1.5, and the temperature is 25°C. As a result, this invention can be applied to a thin-film solar cell module 1 having a large photovoltaic power where a solar cell 27 or a contact line 17 is easily damaged due to a hot spot phenomenon.
Here, AM represents an effect of absorption and scattering of solar light in the air on the wavelength distribution of the intensity of solar light. This is AM 0 in outer space and AM 1 on the surface of the Earth in the case where the light enters vertically to the surface of the Earth. The solar light with AM at 1.5, which is one condition for the output of the solar cell, means that the light has passed through the air layer 1.5 times longer than that of AM 1.
In addition, the output of the cell module 1a can be 50 W, 60 W, 70 W, 80 W, 90 W, 100 W, 110 W, 120 W, 130 W, 140 W, 150 W, 160 W, 170 W, 180 W, 190 W, 200 W, 210 W, 220 W, 230 W, 240 W, 250 W, 260 W, 270 W, 280 W, 290 W, 300 W, 310 W, 320 W, 330 W, 340 W, 350 W, 360 W, 370 W, 380 W or 385 W, for example. The output of the cell module 1a may be any one of these numerical values or less, or may be in a range between any two.

### 1-3. Cell String

Each cell string 21 has a constant width and is provided with a plurality of solar cells 27 having the same width as that of the cell string 21 and being connected in series in a lengthwise direction. In addition, each cell string 21 has two electrodes, one of which is electrically connected to a first common electrode while the other is electrically connected to a second common electrode. These two electrodes may be provided so as to neighbor the solar cells 27 at an end of the plurality of solar cells 27 connected in series in the lengthwise direction. In addition, they may be the same as the front surface electrode or the rear surface electrode of a solar cell 27 at an end. In addition, three or more cell strings 21, each of which has a constant width, are provided on a substrate 2 so as to be aligned in a crosswise direction and connected to each other in parallel. The number of cell strings 21 can be 3, 4, 5, 6, 8, 10, 12, 14, 16, 18, 20, 22, 24, 26, 28 or 30, for example. In addition, the number of cell strings 21 may be in a range between any two of the numbers mentioned here. For example; the number of the cell strings 21 can be 3 or more and 20 or less. As a result, the area of the light receiving surface of the cell strings 21 at the ends can be sufficiently large, and the probability of the entirety or majority of the cell string 21 being in a shade can be reduced. In addition, the cross sectional area of the contact lines 17 can be made sufficiently great.
Here, the cell strings 21 at the ends in the present invention are cell strings 21 in which another cell string 21 is provided on only one side of the cell strings 21 aligned in the crosswise direction. In FIG. 1, for example, the cell strings 21 those neighbor the two ends of the cell module 1a in an X direction from among the cell strings 21 aligned in the X direction.

At least one width L' of the cell strings 21 at the two ends of the three or more cell strings 21 is greater than the width L of the other cell strings 21. As a result, the probability of the entirety or majority of the cell string 21 at one of the ends being in a shade can be reduced. Thus, the contact lines 17 included in the cell string 21 at the end can be prevented from being damaged and an output from the cell module 1a can be prevented from being reduced. As a result, the cross sectional area of the contact lines 17 included in the cell string 21 at the end is great, and therefore even when the entirety or majority of the cell string 21 at the end is in a shade, the density of the power applied to the contact lines 17 is small and the contact lines 17 can be prevented from being damaged.

The form of the cell strings 21 is not particularly limited as long as they have a constant width, but they are actually rectangular (square) and provided so as to be aligned in a width direction.
The cell strings 21 are, for example, rectangular, as shown in FIG. 1, and provided so as to be aligned in the crosswise direction. In addition, the cell strings 21 aligned in the thin-film solar cell module 1 in FIG. 1 are separated from each other by parallel division lines 25 and are electrically connected to each other in parallel through the common electrodes 23. The parallel division lines 25 can be provided so that at least one of the cell strings 21 at the ends has a width greater than that of the other cell strings 21.

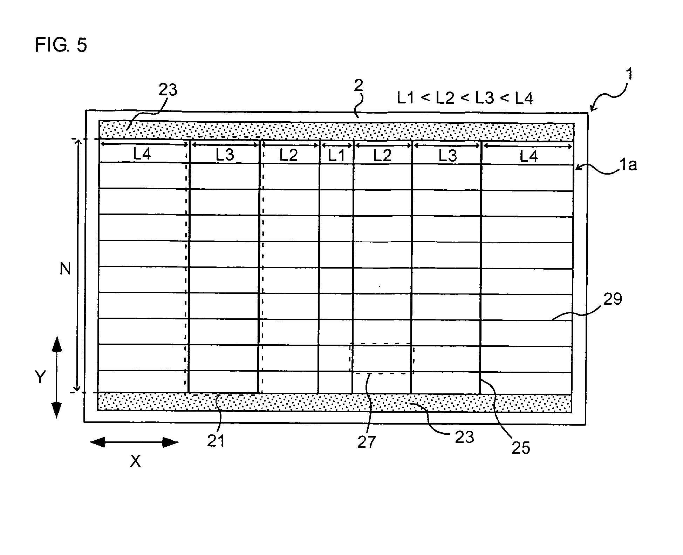

In addition, the cell strings 21 at the two ends included in the cell module 1a can have a width greater than that of the other cell strings 21. As a result, the contact lines 17 can be prevented from being damaged in such an environment that the cell strings 21 at the two ends easily get in a shade.
In addition, the closer the cell string 21 is to an end of the cell module 1a in the crosswise direction, the greater the width of the cell string 21 is. The closer the cell string 21 is to an end of the cell module 1a, the easier it is for the entirety or majority of the cell string 21 to get in a shade, and therefore the above-described structure can prevent the contact lines 17 from being damaged. FIG. 5 is a schematic plan diagram showing the thin-film solar cell module 1 according to one embodiment of the present invention. As shown in FIG. 5, for example, the closer the cell string 21 is to the ends of the cell module 1a in the crosswise direction, the greater the width of the cell string 21 is. Concretely, L1 < L2 < L3 < L4 can be achieved.

In addition, the cell string 21 having the greatest width can have a width three or fewer times greater than the width of the cell string 21 having the smallest width. As a result, the area of the light receiving surface of the cell string 21 having the greatest width at an end of the cell module 1a can be made great, and the probability of the entirety or majority of this cell string 21 getting in a shade can be made small. In addition, the cross sectional area of the contact lines in this cell string 21 can be made sufficiently great. In addition, the cell string 21 having the greatest width can have a width between any two of 1.1, 1.3, 1.5, 1.7, 2, 2.2, 2.5, 2.7 and 3 times greater than the width of the cell string 21 having the smallest width.

In addition, the cell strings 21 can have the same length in the lengthwise direction. This makes it easy for the cell strings to be connected in parallel by means of the common electrodes 23.

In addition, the cell strings 21 can have an output of 30 W or less under a condition of light source: xenon lamp, irradiance: 100 mW/cm², AM: 1.5, and temperature: 25°C. As a result, even in the case where one or a few solar cells 27 included in the cell string 21 is in a shade, this solar cell 27 can be prevented from being damaged due to the hot spot phenomenon (this became clear from the experiment described below). The smaller an output from the cell string 21 is, the more the output can be prevented from lowering due to the hot spot phenomenon. However, when the output is small, the area of the light receiving surface is small, the probability of the entirety of the cell string 21 getting in a shade is high, and the probability of the contact lines 17 being damaged is high. Here, the area of the light receiving surface and the output are in a proportional relationship.

In addition, at least one of the cell strings 21 at the two ends included in the cell module 1a satisfies that the density of the power applied to the contact lines (P - Ps)/Sc is 10.7 (kW/cm²) or less when the output from the cell module 1a is P (W), the output from the cell string 21 is Ps (W), and the cross sectional area of the contact lines 17 included in the cell string 21 is Sc (cm²) under a condition of light source: xenon lamp, irradiance: 100 mW/cm², AM: 1.5, and temperature: 25°C. As a result, even in the case where the entirety of at least one of the cell strings 21 at the two ends included in the cell module 1a is in a shade, the contact lines 17 in this cell string 21 can be prevented from being damaged (this became clear from the experiment described below).
In the case where one cell string 21 is in a shade, the power generated in all the other cell strings 21 is applied to the cell string 21 in a shade. The value of the power applied to the cell string 21 in a shade is (the output P of the cell module 1a) - (the output Ps of the cell string 21 in a shade). The smaller the value of Ps in the cell string 21 is, the greater the value of (P - Ps) is, and therefore when the number of parallel divisions is increased so as to reduce the output Ps of each cell string 21, the power applied to the cell string 21 in a shade increases.

In addition, the cell strings 21 may have the density of the power applied to contact lines (P - Ps)/Sc be 10.7 (kW/cm²) or less when the output of said cell module 1a is P (W), the output of the cell strings 21 is Ps (W), and the area of the cross section of the contact lines 17 included in the cell strings 21 is Sc (cm²) under such conditions that the light source is a xenon lamp, the irradiance is 100 mW/cm², AM is 1.5, and the temperature is 25°C. As a result, the contact lines 17 can be prevented from being damaged even in the case where any cell string 21 in the cell module 1a is in a shade.

### 1-4. Solar Cells

Solar cells 27 are respectively provided with a front surface electrode 3, a photoelectric conversion layer (5, 7, 9) and a rear surface electrode 11 layered in this order. In addition, the solar cells 27 included in a cell string 21 have the same width as the cell string 21 and are connected in series in the lengthwise direction through contact lines 17, which electrically connect the front surface electrode 3 of one solar cell 27 to the rear surface electrode 11 of the adjacent solar cell 27 and have the same width as the cell string 21.
Though the form of the solar cells 27 is not particularly limited, it is practically rectangular or square. For example, a plurality of rectangular solar cells 27 can be connected in series in the direction Y, as in FIG. 1. In addition, in FIG. 1, a plurality of solar cells 27 included in the same cell string 21 are separated from each other through front surface electrode dividing lines (contact lines 17) and rear surface electrode dividing lines 29.

In the case where the thin-film solar cell module 1 is of a superstrate type, a front surface electrode 3, a photoelectric conversion layer (5, 7, 9) and a rear surface electrode 11 are provided and layered on a substrate 2 in this order. In the case where the thin-film solar cell module 1 is of a substrate type, a rear surface electrode 11, a photoelectric conversion layer (5, 7, 9) and a front surface electrode 3 are provided and layered on a substrate 2 in this order.

### 1-4-1. Front Surface Electrode

The front surface electrode 3 is made of a conductive material and has light transmitting properties. The front surface electrode 3 is made of a metal oxide, such as SnO₂, ITO or ZnO, and SnO₂, ITO or the like, which include Sn, are preferable.

### 1-4-2. Photoelectric Conversion Layer

There are no particular limitations in the photoelectric conversion layer as long as it has an n type semiconductor layer and a p type semiconductor layer so as to perform photoelectric conversion. The photoelectric conversion layer may have a pn junction made of an n type semiconductor layer and a p type semiconductor layer or a pin junction made of an n type semiconductor layer, an i type semiconductor layer and a p type semiconductor layer. In addition, the photoelectric conversion layer may have a plurality of pin junctions or pn junctions. A first photoelectric conversion layer 5, a second photoelectric conversion layer 7 and a third photoelectric conversion layer 9 may be provided, for example, as in FIG. 2. Here, the photoelectric conversion layer shown in FIG. 2 is described.

Though a case where the i type semiconductor layers in the first photoelectric conversion layer 5 and the second photoelectric conversion layer 7 are respectively amorphous layers and the i type semiconductor layer in the third photoelectric conversion layer 9 is a microcrystalline layer is cited as an example, the following descriptions can basically be applied for thin-film solar cell modules having other structures, for example, thin-film solar cell modules having such a structure that all of the i type semiconductor layers in the first to third photoelectric conversion layers are all amorphous layers or all crystal layers, thin-film solar cell modules having such a structure that the i type semiconductor layer in the first photoelectric conversion layer is an amorphous layer, and the i type semiconductor layers in the second and third photoelectric conversion layers are both microcrystalline layers, thin-film solar cell modules having such a structure as to omit either or both of photoelectric conversion the second photoelectric conversion layer and the third photoelectric conversion layer, and thin-film solar cell modules having such a structure as to be provided with another photoelectric conversion layer on the downstream side of the third photoelectric conversion layer.
In addition, though a case is cited as an example where a p type semiconductor layer, an i type semiconductor layer and an n type semiconductor layer are aligned in this order in the pin junction in each photoelectric conversion layer, the following description can basically be applied to the case where an n type semiconductor layer, an i type semiconductor layer and a p type semiconductor layer are aligned in this order in the pin junction in each photoelectric conversion layer.

The first photoelectric conversion layer 5 is provided with a p type semiconductor layer 5a, a buffer layer 5b made of an i type amorphous layer, an i type amorphous layer 5c and an n type semiconductor layer 5d layered in this order. The second photoelectric conversion layer 7 is provided with a p type semiconductor layer 7a, a buffer layer 7b made of an i type amorphous layer, an i type amorphous layer 7c and an n type semiconductor layer 7d layered in this order. The third photoelectric conversion layer 9 is provided with a p type semiconductor layer 9a, an i type microcrystalline layer 9b and an n type semiconductor layer 9c layered in this order. The buffer layers 5b and 7b can be left out. The p type semiconductor layers are doped with p type impurity atoms, such as of boron or aluminum, and the n type semiconductor layers are doped with n type impurity atoms, such as phosphorous. The i type semiconductor layers may be completely non-doped semiconductor layers or weak p type or weak n type semiconductor layers with a microscopic amount of impurities and having sufficient photoelectric conversion functions. In the present specification, semiconductor layers means amorphous or microcrystalline semiconductor layers, and amorphous layers and microcrystalline layers mean amorphous and microcrystalline semiconductor layers, respectively.

The materials of the semiconductor layers for forming the photoelectric conversion layers are not particularly limited, and examples are silicon-based semiconductors, CIS (CuInSe2) compound semiconductors and CIGS (Cu(In, Ga)Se₂) compound semiconductors. In the following, a case where the semiconductor layers are made of silicon-based semiconductors is cited as an example. Silicon-based semiconductors means amorphous or microcrystalline silicon or semiconductors where carbon, germanium or another impurity is added to amorphous or microcrystalline silicon (silicon carbide, silicon germanium and the like). In addition, microcrystalline silicon means silicon in a mixed state of crystal silicon having a crystal grains with a small diameter (approximately several tens to several thousands of angstrom) and amorphous silicon. Microcrystalline silicon is formed in the case where a crystal silicon thin film is fabricated at a low temperature in a non-equilibrium process, such as a plasma CVD method, for example.

### 1-4-3. Rear Surface Electrode

The rear surface electrode 11 is made of a conductive material.
The structure and the material of the rear surface electrode 11 are not particularly limited, but in an example, the rear surface electrode 11 has a multilayer structure of a transparent conductive film and a metal film. The transparent conductive film is made of SnO₂, ITO, ZnO or the like. The metal film is made of a metal, such as silver or aluminum. The transparent conductive film and the metal film are formed in accordance with a method, such as CVD, sputtering or vapor deposition.

### 1-5. Contact Lines

Contact lines 17 electrically connect the front surface electrode 3 of one solar cell 27 to the rear surface electrode 11 of an adjacent solar cell that is included in the same cell string 21. As shown in FIG. 2, for example, the front surface electrodes 3 and the rear surface electrodes 11 are electrically connected. In addition, the cross section of the contact lines 17 has the same length L as the width L of the cell strings 21. As a result, when the width L of the cell strings 21 is great, the cross sectional area of the contact lines 17 is also great and wide cell strings can prevent the contact lines 17 from being damaged. As shown in FIG. 3, for example, the cross section of the contact lines 17 has the same length L as the width L of the cell strings 21. In addition, the cross sectional area Sc of the contact lines 17 in FIG. 3 can be represented by the width L of the cell strings 21 × the width W of the contact lines 17 in the lengthwise direction. In addition, in the thin-film solar cell module 1 in FIGs. 1 to 3, the contact lines 17 are formed of a conductor (for example, the same material as of the rear surface electrodes) with which photoelectric conversion layer dividing lines are filled in.

In addition, in the case where one cell string 21 included in the cell module 1a is in a shade and the photovoltaic power of the other cell strings 21 makes a current flow through the cell string 21 in a shade, the current mainly flows through the front surface electrode 3, the contact line 17 and the rear surface electrode 27 included in the cell string 21, and in many cases, the cross sectional area of the contact line 17 is the smallest from among the cross sectional areas of the conductors, and therefore the density of the power applied to the contact line 17 is the greatest.

In addition, the contact line 17 has a cross sectional area Sc of L × W, where W may be 40 µm to 200 µm and L may be 5 cm to 50 cm. As a result, the light receiving area of the solar cells 27 is secured, and in addition, the cross sectional area of the contact lines 17 is sufficiently large. The width W of one side of the cross section of the contact lines 17 is 20 µm to 300 µm, for example, and it is preferable for it to be 40 µm to 200 µm. When the width W of a side of the cross section of the contact lines 17 is small, the area Sc is small, which makes the density of the power applied to the contact lines (P - Ps)/Sc large. When the width W of a side of the cross section of the contact lines 17 is great, the effective power generating area is small. Thus, when the width W of a side of the cross section of the contact lines 17 is 40 µm to 200 µm, the density of the power applied to the contact lines (P - Ps)/Sc is not too large and a wide effective power generating area can be secured. The width W of one side of the cross section of the contact lines 17 is concretely 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, 200 µm, 210 µm, 220 µm, 230 µm, 240 µm, 250 µm, 260 µm, 270 µm, 280 µm, 290 µm or 300 µm. The width W of one side of the cross section of the contact lines 17 may be in a range between any two of the numerical values shown here.

### 2. Plasma CVD apparatus

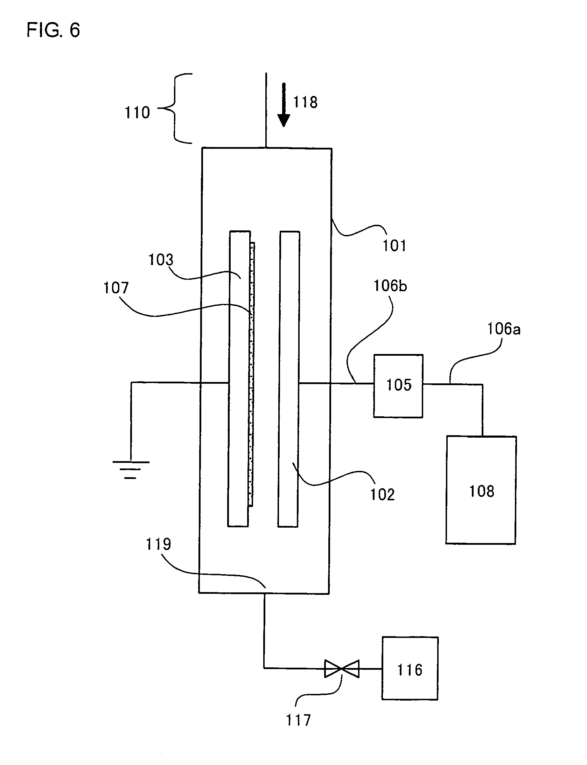

Next, a plasma CVD apparatus for forming a semiconductor layer included in the above-described thin-film solar cell module will be described by use of FIG. 6. FIG. 6 is a sectional view illustrating a structure of a plasma CVD apparatus to be used for production of the thin-film solar cell module according to the present embodiment.

The structure illustrated in FIG. 6 is an exemplification, and the semiconductor layer may be formed by use of an apparatus of another structure. In addition, the semiconductor layer may be formed by a method other than plasma CVD. Here, a plasma CVD apparatus of a single chamber type having one film forming chamber will be described as an example, but the description is also true for a plasma CVD apparatus of a multi-chamber type having a plurality of film forming chambers.

As shown in FIG. 6, the plasma CVD apparatus used in this embodiment includes: a film forming chamber 101 for forming a semiconductor layer therein, which can be hermetically sealed; a gas intake section 110 for introducing a replacement gas into the film forming chamber 101; and a gas exhaust section 116 for evacuating the replacement gas from the film forming chamber 101.

More specifically, the plasma CVD apparatus shown in FIG. 6 has a parallel plate-type electrode structure in which a cathode electrode 102 and an anode electrode 103 are installed in the film forming chamber 101 capable of being hermetically sealed. The distance between the cathode electrode 102 and the anode electrode 103 is determined depending on desired treatment conditions, and it is generally several millimeters to several tens of millimeters. A power supply section 108 for supplying electric power to the cathode electrode 102 and an impedance matching circuit 105 for matching impedances among the power supply section 108, the cathode electrode 102, and the anode electrode 103 are installed outside the film forming chamber 101.

The power supply section 108 is connected to one end of a power introducing line 106a. The other end of the power introducing line 106a is connected to the impedance matching circuit 105. One end of a power introducing line 106b is connected to the impedance matching circuit 105, and the other end of the power introducing line 106b is connected to the cathode electrode 102. The power supply section 108 may output either of a CW (continuous waveform) alternating current output or a pulse-modulated (on/off control) alternating current output, or may be one capable of switching these outputs to output.

The frequency of the alternating electric power outputted from the power supply section 108 is generally 13.56 MHz, but it is not limited thereto, and frequencies of several kHz to VHF band and a microwave band may be used.

On the other hand, the anode electrode 103 is electrically grounded, and a substrate 107 is located on the anode electrode 103. The substrate 107 is, for example, the substrate 2 on which the front surface electrode 3 is formed. The substrate 107 may be placed on the cathode electrode 102, but it is generally placed on the anode electrode 103 in order to reduce degradation of film quality due to ion damage in plasma.

The gas intake section 110 is provided in the film forming chamber 101. A gas 118 such as a dilution gas, a material gas, and a doping gas is introduced from the gas intake section 110. Examples of the dilution gas include a gas including a hydrogen gas. Examples of the material gas include a silane base gas, a methane gas, a germane gas, and the like. Examples of the doping gas include a doping gas of a p-type impurity such as a diborane gas, and a doping gas of an n-type impurity such as a phosphine gas.

Further, the gas exhaust section 116 and a pressure control valve 117 are connected in series to the film forming chamber 101, and the gas pressure in the film forming chamber 101 is kept approximately constant. It is desirable that the gas pressure is measured at a position away from the gas intake section 110 and a gas exhaust outlet 119 in the film forming chamber, because measurement of the gas pressure at a position close to the gas intake section 110 and the gas exhaust outlet 119 causes errors somewhat. By supplying electric power to the cathode electrode 102 under this condition, it is possible to generate plasma between the cathode electrode 102 and the anode electrode 103 to decompose the gas 118, and to form the semiconductor layer on the substrate 107.

The gas exhaust section 116 may be one capable of evacuating the film forming chamber 101 to reduce the gas pressure in the film forming chamber 101 to a high vacuum of approximately 1.0 × 10⁻⁴ Pa, but it may be one having an ability for evacuating gases in the film forming chamber 101 to a pressure of approximately 0.1 Pa in view of simplification of an apparatus, cost reduction, and an increase in throughput. The volume of the film forming chamber 101 has been getting larger as the size of the substrate of the semiconductor device grows. When such a film forming chamber 101 is highly evacuated to a vacuum, a high-performance gas exhaust section 116 is required, and therefore it is not desirable from the viewpoint of simplification of an apparatus and cost reduction, and it is more desirable to use a simple gas exhaust section 116 for a low vacuum.

Examples of the simple gas exhaust section 116 for a low vacuum include a rotary pump, a mechanical booster pump, a sorption pump, and the like, and it is preferable to use these pumps alone or in combination of two or more kinds thereof.

The film forming chamber 101 of the plasma CVD apparatus used in this embodiment can be sized in approximately 1 m³, for example. As a typical gas exhaust section 116, a mechanical booster pump and a rotary pump connected in series can be used.

### 3. Method for producing thin-film solar cell module

Next, a method for producing the thin-film solar cell module according to an embodiment of the present invention will be described by use of FIG. 1, FIG. 2, FIGs. 3 (a) (b), and FIG. 6.

Hereinafter, the method will be described taking, as an example, the case of forming the semiconductor layer by use of a plasma CVD apparatus of a single chamber type having one film forming chamber as shown in Fig. 6, but the following description is basically also true for the case of forming the semiconductor layer by use of a plasma CVD apparatus of a multi-chamber type. However, with the plasma CVD apparatus of a multi-chamber type, a gas replacement step to be described later can be omitted, because the p-type, the i-type, and the n-type semiconductor layers can be formed in different film forming chambers.

In the production method of this embodiment, the first photoelectric conversion layer 5, the second photoelectric conversion layer 7, and the third photoelectric conversion layer 9 are formed in the same film forming chamber. To form the photoelectric conversion layers in the same film forming chamber means that the first, second, and third photoelectric conversion layers 5, 7, 9 are formed by use of the same electrode or different electrodes in the same film forming chamber, and it is desirable that the first, second, and third photoelectric conversion layers 5, 7, 9 are formed by use of the same electrode in the same film forming chamber. Further, it is desirable from the viewpoint of improving production efficiency that the first, second, and third photoelectric conversion layers 5, 7, 9 are successively formed without being released to the air on the way. Furthermore, it is desirable from the viewpoint of improving production efficiency that substrate temperatures during the formation of the first, second, and third photoelectric conversion layers 5, 7, 9, are the same.

Hereinafter, a method for producing the thin-film solar cell module 1 will be described in detail. The method to be described below is exemplification, and the thin-film solar cell module 1 may be produced by a method other than the method to be described below.

### 3-1. Step of forming front surface electrode

First, the front surface electrode 3 is formed on the substrate 2. For example, they may be formed by a method such as a CVD method, a sputtering method, and a vapor deposition method.

### 3-2. Step of forming front surface electrode division line

Next, the front surface electrode division line 13 dividing the front surface electrode 3 is formed in a crosswise direction. For example, the front surface electrode division line 13 extending in an X direction in FIG. 1 (in a direction of a longer side of the substrate 2; in a direction in which the plurality of cell strings 21 in the cell module 1a are arranged) is formed on the front surface electrode 3, thereby dividing the front surface electrode 3 into a pattern of a plurality of band-like shapes. The front surface electrode division line 13 may be formed by, for example, scribing the front surface electrode 3 by use of a fundamental wave of a YAG laser.

### 3-3. Step of forming first photoelectric conversion layer

Next, the first photoelectric conversion layer 5 is formed on the obtained substrate. As described above, since the first photoelectric conversion layer 5 has the p-type semiconductor layer 5a, the buffer layer 5b, the i-type amorphous layer 5c, and the n-type semiconductor layer 5d, the respective semiconductor layers are formed in order.

A gas replacement step of replacing the inside of the film forming chamber 101 with a replacement gas is performed to reduce the concentration of impurities in the film forming chamber 101 before the formation of the p-type semiconductor layer 5a (that is, before the formation of the first photoelectric conversion layer 5) and before the formation of the i-type amorphous layer 5c. Since the impurities introduced in the preceding step or the impurities immixed from the outside when a substrate is carried into the film forming chamber 101 remain in the film forming chamber 101, quality of the semiconductor layer is deteriorated if the semiconductor layer takes in the impurities. Therefore, the concentration of the impurities in the film forming chamber 101 is reduced in advance. The gas replacement step is also performed before the formation of the p-type semiconductor layer 7a (that is, before the formation of the second photoelectric conversion layer 7), before the formation of the i-type amorphous layer 7c, before the formation of the p-type semiconductor layer 9a (that is, before the formation of the third photoelectric conversion layer 9), and before the formation of the i-type microcrystalline layer 9b. Here, each gas replacement step may be performed under the same condition, or under different conditions.

In addition, when the plasma CVD apparatus of a multi-chamber type is used, the concentration of the impurities in the film forming chamber can be reduced by changing the film forming chamber in place of performing the gas replacement step. In general, the p-type semiconductor layer 5a and the buffer layer 5b are formed in a first film forming chamber, the i-type amorphous layer 5c is formed in a second film forming chamber, and the n-type semiconductor layer 5d is formed in a third film forming chamber. Further, the p-type semiconductor layer 7a, the buffer layer 7b, and the p-type semiconductor layer 9a are formed in the first film forming chamber, the i-type amorphous layer 7c and the i-type microcrystalline layer 9b are formed in the second film forming chamber, and the n-type semiconductor layer 7d and the n-type semiconductor layer 9c are formed in the third film forming chamber. The p-type amorphous layer and the buffer layer may be formed in different film forming chambers.
Hereinafter, a step of forming the first photoelectric conversion layer 5 will be described in detail.

### 3-3-1. Gas replacement step

The substrate 2 on which the front surface electrode 3 is formed is installed in the film forming chamber 101, and thereafter the gas replacement step of replacing the inside of the film forming chamber 101 with a replacement gas is performed. This gas replacement step is performed to reduce the concentration of the impurities which are immixed from the outside of the film forming chamber 101 in carrying a substrate to be provided with a semiconductor layer into the film forming chamber 101. Further, when the thin-film solar cell module is produced repeatedly, the first to third photoelectric conversion layers are formed repeatedly, and therefore the n-type semiconductor layer 9c of the third photoelectric conversion layer 9, previously formed, is deposited on an inner wall, an electrode, and the like in the film forming chamber 101. Therefore, it will be a problem that impurities released from the n-type semiconductor layer 9c of the third photoelectric conversion layer 9, particularly impurities that determine a conductive type of the n-type semiconductor layer 9c of the third photoelectric conversion layer 9, are immixed in the p-type semiconductor layer 5a of the first photoelectric conversion layer 5. Accordingly, the gas replacement step is performed before the formation of the p-type semiconductor layer 5a to reduce the amount of n-type impurities to be immixed in the p-type semiconductor layer 5a.

Thereby, a semiconductor layer of good quality can be formed as the p-type semiconductor layer 5a of the first photoelectric conversion layer 5. Here, since the p-type semiconductor layer 5a generally includes p-type conductive impurities in a concentration of approximately 1 × 10²⁰ cm⁻³, satisfactory photoelectric conversion characteristics are attained if the concentration of the immixed n-type conductive impurities is approximately 1 × 10¹⁸ cm⁻³ or less, which is 2 digits less than the concentration of the p-type conductive impurities.

The gas replacement step can be performed through an operation cycle in which, for example, a hydrogen gas is introduced into the film forming chamber 101 as a replacement gas (step of introducing a replacement gas), the introduction of the hydrogen gas is stopped when the internal pressure of the film forming chamber 101 reaches a predetermined pressure (for example, approximately 100 Pa to 1000 Pa), and the hydrogen gas is evacuated until the internal pressure of the film forming chamber 101 reaches a predetermined pressure (for example, approximately 1 Pa to 10 Pa) (evacuation step). This cycle may be repeated more than once.

The period of time required to perform the above-mentioned one cycle can be several seconds to several tens of seconds. Specifically, the step of introducing a replacement gas can be performed over 1 to 5 seconds, and the evacuation step can be performed over 30 to 60 seconds. Even when the steps are performed in such a short period of time, the concentration of the impurities in the film forming chamber can be reduced by repeating this cycle more than once. Therefore, the method for producing the thin-film solar cell module according to this embodiment is also practical when it is applied to mass production devices.

In this embodiment, it is preferable that an internal pressure of the film forming chamber 101 after introducing a replacement gas and an internal pressure after evacuating the replacement gas are set in advance. In the step of introducing a replacement gas, the evacuation from the film forming chamber 101 is stopped, and when the internal pressure of the film forming chamber 101 reaches above the internal pressure after introducing the replacement gas, the introduction of the replacement gas is stopped to terminate the step of introducing a replacement gas. In the evacuation step, the introduction of the replacement gas is stopped, and when the internal pressure of the film forming chamber 101 reaches below the internal pressure after evacuating the replacement gas, the evacuation is stopped to terminate the evacuation step.

By increasing the number of repetitions of the cycle, or by decreasing the ratio (M/m) of a pressure M after evacuating the replacement gas to a pressure m after introducing the replacement gas, the concentration of the impurities existing in the film forming chamber 101 can be more reduced.

Further, in this embodiment, the present invention is described taking, as an example, the case where a hydrogen gas is used as a replacement gas, but in another embodiment, any gas usable for formation of an i-type layer, such as a silane gas, may be used as a replacement gas. The gas usable for the formation of the i-type layer are also usable for the formation of any of the p-type, i-type, and n-type semiconductor layers. Accordingly, it is preferable to use a gas used for the formation of the i-type layer as a replacement gas, because in this case, no impurity from this gas is immixed in the semiconductor layer.

Further, in another embodiment, an inert gas or the like, which does not have an effect on film quality of the semiconductor layer may be used as a replacement gas. In particular, a gas having a large atomic weight is apt to remain in the film forming chamber 101 after the evacuation of the inside of the film forming chamber 101 and is suitable for a replacement gas. Examples of the inert gas include an argon gas, a neon gas, a xenon gas, and the like.

Further, the replacement gas may be a mixture gas of any one or more of gases usable for the formation of the i-type layer and one or more inert gases.

### 3-3-2. Step of forming p-type semiconductor layer

Next, the p-type semiconductor layer 5a is formed. Hereinafter, a step of forming the p-type semiconductor layer 5a will be described.

First, the inside of the film forming chamber 101 can be evacuated to a pressure of 0.001 Pa and the substrate temperature can be set at a temperature of 200°C or lower. Thereafter, the p-type semiconductor layer 5a is formed. A mixture gas is introduced into the film forming chamber 101 and the internal pressure of the film forming chamber 101 is kept approximately constant by a pressure control valve 117 provided in an exhaust system. The internal pressure of the film forming chamber 101 is in a range of, for example, 200 Pa to 3600 Pa. As the mixture gas to be introduced into the film forming chamber 101, for example, a gas including a silane gas, a hydrogen gas, and a diborane gas can be used. Further, the mixture gas can include a gas (for example, methane gas) containing carbon atoms in order to reduce the amount of light absorption. The flow rate of the hydrogen gas can be 5 times or more and 300 times or less larger than that of the silane gas, and it is preferably approximately 5 times to 30 times in the case of forming a p-type amorphous layer, and 30 times to 300 times in the case of forming a p-type microcrystalline layer.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an amorphous or microcrystalline p-type semiconductor layer 5a. The power density per unit area of the cathode electrode 102 is preferably in a range of 0.01 W/cm² to 0.3 W/cm² in the case of forming a p-type amorphous layer, and it is preferably in a range of 0.02 W/cm² to 0.5 W/cm2 in the case of forming a p-type microcrystalline layer.

Thus, the p-type semiconductor layer 5a having a desired thickness is formed, and then input of the alternating electric power is stopped and the film forming chamber 101 is evacuated to a vacuum.

The thickness of the p-type semiconductor layer 5a is preferably 2 nm or more, more preferably 5 nm or more in terms of providing an adequate internal electric field for the i-type amorphous layer 5c. Further, the thickness of the p-type semiconductor layer 5a is preferably 50 nm or less, more preferably 30 nm or less in terms of necessity for suppressing the amount of light absorption on a side of light entrance of an inactive layer.

### 3-3-3. Step of forming buffer layer

Next, an i-type amorphous layer is formed as the buffer layer 5b. First, a background pressure in the film forming chamber 101 is evacuated to a vacuum of approximately 0.001 Pa. The substrate temperature can be set at a temperature of 200°C or lower. Next, a mixture gas is introduced into the film forming chamber 101, and the internal pressure of the film forming chamber 101 is kept approximately constant by the pressure control valve 117. The internal pressure of the film forming chamber 101 is adjusted to be in a range of, for example, 200 Pa to 3000 Pa. As the mixture gas to be introduced into the film forming chamber 101, for example, a gas including a silane gas and a hydrogen gas can be used. Further, the mixture gas can include a gas (for example, methane gas) containing carbon atoms in order to reduce the amount of light absorption. Desirably, the flow rate of a hydrogen gas is approximately several times to several tens of times larger than that of a silane gas.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an i-type amorphous layer as the buffer layer 5b. The power density per unit area of the cathode electrode 102 may be in a range of 0.01 W/cm² to 0.3 W/cm².

Thus, the i-type amorphous layer having a desired thickness is formed as the buffer layer 5b, and then input of the alternating electric power is stopped and the inside of the film forming chamber 101 is evacuated to a vacuum.

By forming the i-type amorphous layer as the buffer layer 5b, the concentration of boron atoms in atmosphere in the film forming chamber 101 is reduced to allow reduction of boron atoms to be immixed in the i-type amorphous layer 5c to be formed next.

The thickness of the i-type amorphous layer as the buffer layer 5b is desirably 2 nm or more in order to inhibit diffusion of boron atoms from the p-type semiconductor layer 5a to the i-type amorphous layer 5c. On the other hand, this thickness is desirably as small as possible in order to suppress the amount of light absorption to increase light reaching the i-type amorphous layer 5c. The thickness of the buffer layer 5b is generally adjusted to 50 nm or less.

### 3-3-4. Gas replacement step

Next, a gas replacement step is performed in the same manner as in "3-3-1. Gas replacement step".

The p-type semiconductor layer 5a, formed in the preceding step, is deposited on an inner wall and an electrode in the film forming chamber 101. Therefore, it will be a problem that impurities released from the p-type semiconductor layer 5a, particularly impurities that determine a conductive type of the p-type semiconductor layer 5a are immixed in the i-type amorphous layer 5c, but by performing the gas replacement step before the formation of the i-type amorphous layer 5c, the amount of the above-mentioned impurities to be immixed in the i-type amorphous layer 5c can be reduced. Thereby, a semiconductor layer of good quality can be formed as the i-type amorphous layer 5c.

### 3-3-5. Step of forming i-type amorphous layer

Next, the i-type amorphous layer 5c is formed. First, the background pressure in the film forming chamber 101 is evacuated to a vacuum of approximately 0.001 Pa. The substrate temperature can be set at a temperature of 200°C or lower. Next, a mixture gas is introduced into the film forming chamber 101 and the internal pressure of the film forming chamber 101 is kept approximately constant by the pressure control valve 117. The internal pressure of the film forming chamber 101 is adjusted to be in a range of, for example, 200 Pa to 3000 Pa. As the mixture gas to be introduced into the film forming chamber 101, for example, a gas including a silane gas and a hydrogen gas can be used. The flow rate of the hydrogen gas is preferably approximately several times to several tens of times larger than that of the silane gas, more preferably 5 times or more and 30 times or less. In this case, the i-type amorphous layer 5c of good film quality can be formed.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming the i-type amorphous layer 5c. The power density per unit area of the cathode electrode 102 can be in a range of 0.01 W/cm² to 0.3 W/cm².

Thus, the i-type amorphous layer 5c having a desired thickness is formed, and then input of the alternating electric power is stopped and the inside of the film forming chamber 101 is evacuated to a vacuum.

The thickness of the i-type amorphous layer 5c is preferably set at 0.05 µm to 0.25 µm in consideration of the amount of light absorption and deterioration of photoelectric conversion characteristics due to light degradation.

### 3-3-6. Step of forming n-type semiconductor layer

Next, the n-type semiconductor layer 5d is formed. First, the background pressure in the film forming chamber 101 is evacuated to a vacuum of approximately 0.001 Pa. The substrate temperature can be set at a temperature of 200°C or lower, for example 150°C. Next, a mixture gas is introduced into the film forming chamber 101 and the internal pressure of the film forming chamber 101 is kept approximately constant by the pressure control valve 117. The internal pressure of the film forming chamber 101 is adjusted to be in a range of, for example, 200 Pa to 3600 Pa. As the mixture gas to be introduced into the film forming chamber 101, a gas including a silane gas, a hydrogen gas, and a phosphine gas can be used. The flow rate of the hydrogen gas can be 5 times or more and 300 times or less larger than that of the silane gas, and it is preferably approximately 5 times to 30 times in the case of forming an n-type amorphous layer, and 30 times to 300 times in the case of forming an n-type microcrystalline layer.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an amorphous or microcrystalline n-type semiconductor layer 5d. The power density per unit area of the cathode electrode 102 is preferably in a range of 0.01 W/cm² to 0.3 W/cm² in the case of forming an n-type amorphous layer, and it is preferably in a range of 0.02 W/cm² to 0.5 W/cm² in the case of forming an n-type microcrystalline layer.

The thickness of the n-type semiconductor layer 5d is preferably 2 nm or more in order to provide an adequate internal electric field for the i-type amorphous layer 5c. On the other hand, the thickness of the n-type semiconductor layer 5d is preferably as small as possible in order to suppress the amount of light absorption in the n-type semiconductor layer 5d as an inactive layer, and it is generally adjusted to 50 nm or less.

Thus, the first photoelectric conversion layer 5 including the i-type amorphous layer 5c can be formed.

### 3-4. Step of forming second photoelectric conversion layer

Next, the second photoelectric conversion layer 7 is formed on the obtained substrate. As described above, the second photoelectric conversion layer 7 has the p-type semiconductor layer 7a, the buffer layer 7b, the i-type amorphous layer 7c, and the n-type semiconductor layer 7d, and the respective semiconductor layers are therefore formed in order.
Hereinafter, a step of forming the second photoelectric conversion layer 7 will be described in detail.

### 3-4-1. Gas replacement step

Next, a gas replacement step is performed in the same manner as in "3-3-1. Gas replacement step". By performing this gas replacement step, it is possible to reduce the amount of impurities released from the n-type semiconductor layer deposited on an inner wall and an electrode in the film forming chamber 101 during the formation of the n-type semiconductor layer 5d, particularly impurities that determine a conductive type of the n-type semiconductor layer 5d to be immixed in the p-type semiconductor layer 7a. Thereby, a semiconductor layer of good quality can be formed as the p-type semiconductor layer 7a. Here, since the p-type semiconductor layer 7a includes p-type conductive impurities in a concentration of approximately 1 × 10²⁰ cm⁻³, satisfactory photoelectric conversion characteristics are attained if the concentration of immixed n-type conductive impurities is approximately 1 × 10¹⁸ cm⁻³ or less, which is 2 digits less than the concentration of the p-type conductive impurities.

### 3-4-2. Step of forming p-type semiconductor layer

Next, the p-type semiconductor layer 7a is formed. The p-type semiconductor layer 7a can be formed in the same manner as in the formation of the p-type semiconductor layer 5a of the first photoelectric conversion layer 5.

### 3-4-3. Step of forming buffer layer

Next, the buffer layer 7b is formed in the same manner as in the formation of the buffer layer 5b of the first photoelectric conversion layer 5.

### 3-4-4. Gas replacement step

Next, a gas replacement step is performed in the same manner as in "3-3-1. Gas replacement step". In this gas replacement step, an effect identical or similar to that in the gas replacement step performed before the formation of the i-type amorphous layer 5c of the first photoelectric conversion layer 5 can be attained.

### 3-4-5. Step of forming i-type amorphous layer

Next, the i-type amorphous layer 7c is formed.
The thickness of the i-type amorphous layer 7c is preferably set at 0.1 µm to 0.7 µm in consideration of the amount of light absorption and deterioration of the photoelectric conversion characteristics due to light degradation.

Further, it is desirable that the bandgap of the i-type amorphous layer 7c of the second photoelectric conversion layer 7 is narrower than the bandgap of the i-type amorphous layer 5c of the first photoelectric conversion layer 5. This is because, by forming such a bandgap, light of wavelength band that the first photoelectric conversion layer 5 cannot absorb can be absorbed in the second photoelectric conversion layer 7, and incident light can be utilized effectively.

In order to narrow the bandgap of the i-type amorphous layer 7c, the substrate temperature during the film formation can be set at a higher temperature. By increasing the substrate temperature, the concentration of hydrogen atoms contained in the film can be reduced and an i-type amorphous layer 7c having a small bandgap can be formed. That is, it is only necessary to adopt a substrate temperature for the formation of the i-type amorphous layer 7c of the second photoelectric conversion layer 7 higher than the substrate temperature for the formation of the i-type amorphous layer 5c of the first photoelectric conversion layer 5. Thereby, it is possible to make the concentration of hydrogen atoms in the i-type amorphous layer 5c of the first photoelectric conversion layer 5 higher than the concentration of hydrogen atoms in the i-type amorphous layer 7c of the second photoelectric conversion layer 7 and to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7.

Further, by decreasing the flow rate ratio of a hydrogen gas to a silane gas of a mixture gas to be introduced into the film forming chamber 101 in the formation of the i-type amorphous layer 7c, the concentration of hydrogen atoms contained in the i-type amorphous layer 7c can be reduced and the i-type amorphous layer 7c having a narrow bandgap can be formed. That is, it is only necessary to adopt a flow rate ratio of the hydrogen gas to the silane gas of the mixture gas in the formation of the i-type amorphous layer 7c of the second photoelectric conversion layer 7 smaller than that in the formation of the i-type amorphous layer 5c of the first photoelectric conversion layer 5. Thereby, it is possible to make the concentration of hydrogen atoms in the i-type amorphous layer 5c of the first photoelectric conversion layer 5 higher than the concentration of hydrogen atoms in the i-type amorphous layer 7c of the second photoelectric conversion layer 7 and to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7.

Furthermore, it is also possible to adjust the bandgap of the i-type amorphous layer by selecting either forming the i-type amorphous layer by continuous discharge plasma or forming the i-type amorphous layer by pulse discharge plasma. When the i-type amorphous layer is formed by continuous discharge plasma, the concentration of hydrogen atoms contained into the i-type amorphous layer to be formed can be made higher than that in the case of forming the i-type amorphous layer by pulse discharge plasma.

Accordingly, it is possible to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7 by switching supply electric power for generating plasma so that the i-type amorphous layer 5c of the first photoelectric conversion layer 5 can be formed by continuous discharge plasma and the i-type amorphous layer 7c of the second photoelectric conversion layer 7 can be formed by pulse discharge plasma.

The setting of the substrate temperatures for the formation of the i-type amorphous layer 5c of the first photoelectric conversion layer 5 and the i-type amorphous layer 7c of the second photoelectric conversion layer 7, the setting of the flow rate ratio of the hydrogen gas to the silane gas, and the setting of the switching between the continuous discharge and the pulse discharge may be done separately, or the respective settings may be used in combination. In particular, when the substrate temperatures for the formation of the i-type amorphous layer 5c of the first photoelectric conversion layer 5 and the i-type amorphous layer 7c of the second photoelectric conversion layer 7 are the same, concurrent use of the setting of the flow rate ratio of the hydrogen gas to the silane gas and the switching between the continuous discharge and the pulse discharge is desirable, because it allows the concentration of hydrogen atoms contained in the i-type amorphous layer to be changed by a large amount.

### 3-4-6. Step of forming n-type semiconductor layer

Next, the n-type semiconductor layer 7d is formed. The n-type semiconductor layer 7d can be formed in the same manner as in the formation of the n-type semiconductor layer 5d of the first photoelectric conversion layer 5.

### 3-5. Step of forming third photoelectric conversion layer

Next, the third photoelectric conversion layer 9 is formed on the obtained substrate. As described above, the third photoelectric conversion layer 9 has the p-type semiconductor layer 9a, the i-type microcrystalline layer 9b, and the n-type semiconductor layer 9c, and the respective semiconductor layers are therefore formed in order.
Hereinafter, a step of forming the third photoelectric conversion layer 9 will be described in detail.

### 3-5-1. Gas replacement step

First, a gas replacement step is performed in the same manner as in "3-3-1. Gas replacement step". This gas replacement step has an effect identical or similar to that in the gas replacement step performed before the formation of the second photoelectric conversion layer 7.

### 3-5-2. Step of forming p-type semiconductor layer

Next, the p-type semiconductor layer 9a is formed. The p-type semiconductor layer 9a can be formed in the same manner as in the formation of the p-type semiconductor layer 5a of the first photoelectric conversion layer 5.

### 3-5-3. Gas replacement step

Next, a gas replacement step is performed in the same manner as in "3-3-1. Gas replacement step". This gas replacement step has an effect identical or similar to that in the gas replacement step performed before the formation of the i-type amorphous layer 5c of the first photoelectric conversion layer 5 and the i-type amorphous layer 7c of the second photoelectric conversion layer 7.

### 3-5-4. Step of forming i-type microcrystalline layer

Next, the i-type microcrystalline layer 9b is formed. The i-type microcrystalline layer 9b can be formed, for example, under the following formation conditions. The substrate temperature is desirably set at a temperature of 200°C or lower. The internal pressure of the film forming chamber 101 during the formation of the layer is desirably in a range of 240 Pa to 3600 Pa. Further, the power density per unit area of the cathode electrode 102 is desirably set to be in a range of 0.02 W/cm² to 0.5 W/cm².

As a mixture gas to be introduced into the film forming chamber 101, for example, a gas including a silane gas and a hydrogen gas may be used. The flow rate of the hydrogen gas is desirably approximately 30 times to several hundreds of times larger than that of the silane gas, more desirably approximately 30 times to 300 times.

The thickness of the i-type microcrystalline layer 9b is preferably 0.5 µm or more, more preferably 1 µm or more in order to secure an adequate amount of light absorption. On the other hand, the thickness of the i-type microcrystalline layer 9b is preferably 20 µm or less, more preferably 15 µm or less in order to secure good productivity.

Thus, an i-type microcrystalline layer 9b having a good crystallinity, in which the intensity ratio I₅₂₀/I₄₈₀) of a peak at 520 nm⁻¹ to a peak at 480 nm⁻¹, measured by Raman spectroscopy, is in a range of 3 to 10 can be formed.

### 3-5-5. Step of forming n-type semiconductor layer

Next, the n-type semiconductor layer 9c is formed. The n-type semiconductor layer 9c can be formed in the same manner as in the formation of the n-type semiconductor layer 5d of the first photoelectric conversion layer 5.

### 3-6. Step of forming photoelectric conversion layer division line

Next, the photoelectric conversion layer division line is formed in the first to third photoelectric conversion layers 5, 7, 9 so as to extend in the crosswise direction (in the X direction in FIG. 1) and so as to be off the position of the front surface electrode division line 13, thereby dividing the first to third photoelectric conversion layers 5, 7, 9 into a pattern of a plurality of band-like shapes. The photoelectric conversion layer division line can be formed by scribing the first to third photoelectric conversion layers 5, 7, 9 by use of second higher harmonics of a YAG laser, for example. Here, the contact lines 17 are formed of a conductor (for example, the material for the rear surface electrodes) with which the photoelectric conversion layer dividing lines are filled in, and therefore the width of the photoelectric conversion layer dividing lines is the same as the width of the contact lines 17.

### 3-7. Step of forming rear surface electrode

Next, the rear surface electrode 11 is formed on the third photoelectric conversion layer 9. The rear surface electrode 11 has a transparent conductive film and a metal film in this order from a side of the third photoelectric conversion layer 9, and these films are therefore formed in order.

The transparent conductive film is formed of SnO₂, ITO, ZnO, or the like. The metal film is formed of a metal such as silver and aluminum. The transparent conductive film and the metal film are formed by a method such as a CVD method, a sputtering method, and a vapor deposition method. The transparent conductive film may be omitted.

When the rear surface electrode 11 is formed, a material of the rear surface electrode 11 gets into the photoelectric conversion layer division line to form the contact line 17.

### 3-8. Step of forming rear surface electrode division line

Next, the rear surface electrode division line 29 extending in the crosswise direction (in the X direction in FIG. 1) is formed in the rear surface electrode 11 and the first to third photoelectric conversion layers 5, 7, 9, thereby dividing the rear surface electrode 11 and the first to third photoelectric conversion layers 5, 7, 9 into a pattern of a plurality of band-like shapes. The rear surface electrode division line 29 is formed so that the three lines are arranged in order of the front surface electrode division line 13, the photoelectric conversion layer division line, and the rear surface electrode division line 29.

The rear surface electrode division line 29 can be formed by scribing the rear surface electrode 11 and the first to third photoelectric conversion layers 5, 7, 9 by use of second higher harmonics of a YAG laser, for example.
Through the steps that have been described so far, the band-shaped cell string 21 having the plurality of cells 27 connected to each other in series is obtained.

### 3-9. Step of Forming Alignment Dividing Lines

Next, alignment dividing lines 25 running in the lengthwise direction (the direction Y in FIG. 1, the direction in which the shorter sides of the substrate 2 run, the direction in which a plurality of solar cells 27 are aligned in the cell strings 21) are formed in the band-like cell string 21 so that the band-like cell string 21 is divided into a plurality of cell strings 21. At this time, the locations where the alignment dividing lines 25 are formed are adjusted so that the width of the cell string 21 at the end can be greater than the width of the other cell strings 21.

The Alignment dividing line 25 can be formed by scribing the rear surface electrode 11 and the first to third photoelectric conversion layers 5, 7, 9 by use of second higher harmonics of a YAG laser, for example, and by further scribing the front surface electrode 3 by use of a fundamental wave of a YAG laser.

### 3-10. Step of forming common electrode

Next, the common electrode 23 is installed so that the plurality of cell strings 21 are connected to each other in parallel to complete production of the thin-film solar cell module 1 of this embodiment.

### 4. Thin-Film Solar Cell Array

The present invention also provides a thin-film solar cell array in which the thin-film solar cell module according to the present invention is installed. In the thin-film solar cell array according to one embodiment of the present invention, the thin-film solar cell module according to the present invention is installed so that the light receiving surface inclines relative to the horizontal plane, and the cell string having the greatest width is placed in the lower portion. The angle of inclination can be 10 degrees to 80 degrees depending on the latitude of the place where the thin-film solar cell array is installed. As a result, in the case where snow accumulates on the thin-film solar cell module and then the snow remains only in the lower portion of the thin-film solar cell module or in the case where the module gets in a shade of another module, the entirety of the cell string in the lower portion of the thin-film solar cell module gets in a shade and a contact line in the cell string in the lower portion may be damaged due to the effects of the other cell strings. However, when the cell string 21 at an end having a width greater than that of the other cell strings 21 is placed in the lower portion, the contact lines in the cell string in the lower portion can be prevented from being damaged.

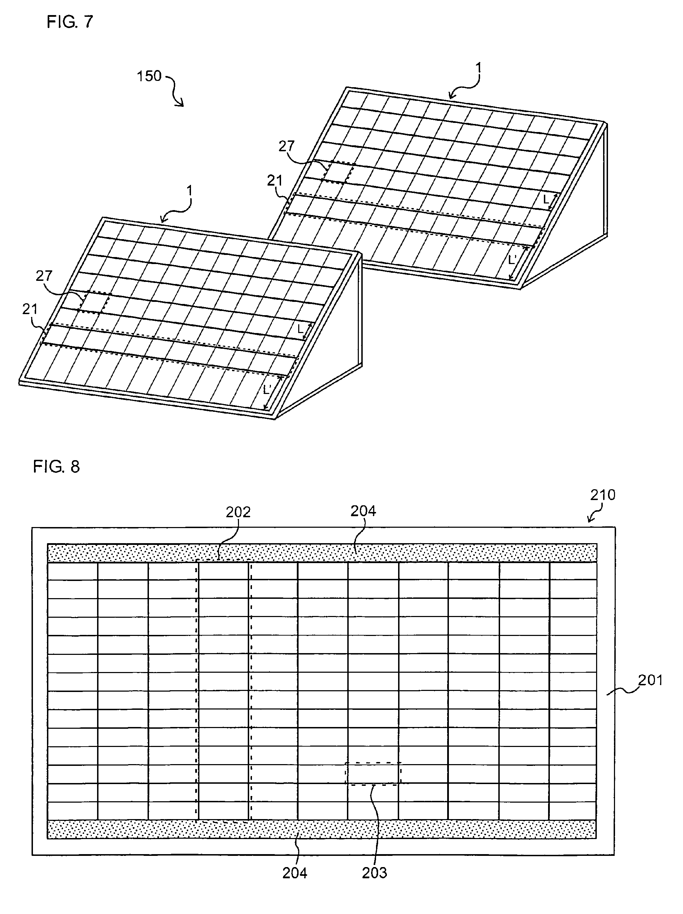

FIG. 7 is a schematic perspective diagram showing the thin-film solar cell array according to one embodiment of the present invention. The thin-film solar cell array 150 according to the present embodiment is installed so as to be inclined as in FIG. 7, for example, and the cell string having the greatest width can be placed in the lower portion.

### 5. Cell hotspot resistance test

A cell hotspot resistance test was performed by the following method.
First, a large number of samples having the same configuration (except that there is no Alignment dividing line 25 and no common electrode 23) as that of the thin-film solar cell module of the embodiment described above with reference to FIG. 1, FIG. 2, FIG. 3 were produced by using materials shown in Table 1. The number of series connection stages of each sample was 30.

**Table 1**

| Element | | Material |
|---|---|---|
| Substrate 2 | | Glass |
| First electrode 3 | | SnO₂ (projection-and-recess shape on surface) |
| First photoelectric conversion layer 5 | P-type semiconductor layer 5a (amorphous layer) | Amorphous silicon carbide |
| | Buffer layer 5b | Amorphous silicon carbide |
| | I-type amorphous layer 5c | Amorphous silicon |
| | N-type semiconductor layer 5d (amorphous layer) | Amorphous silicon |
| Second photoelectric conversion layer 7 | P-type semiconductor layer 7a (amorphous layer) | Amorphous silicon carbide |
| | Buffer layer 7b | Amorphous silicon carbide |
| | I-type amorphous layer 7c | Amorphous silicon |
| | N-type semiconductor layer 7d (amorphous layer) | Amorphous silicon |
| Third photoelectric conversion layer 9 | P-type semiconductor layer 9a (microcrystalline layer) | Microcrystalline silicon |
| | I-type microcrystalline layer 9b | Microcrystalline silicon |
| | N-type semiconductor layer 9c (microcrystalline layer) | Microcrystalline silicon |
| Second electrode 11 | Transparent conductive film | ZnO |
| | Metal film | Ag |

Each sample produced was measured for an I-V property and an RB current (a current when a voltage of 5 V to 8 V was applied in a reverse direction; the voltage applied was appropriately varied so that the RB current values shown in Table 2 were obtained).

Next, samples that are different from one another in RB current were selected out of the above-described samples. Each of the selected samples was divided in parallel, thereby obtaining a 5 W to 50 W of output of the cell string 21 being evaluated.

Next, the hotspot resistance test was performed on a cell 27 having the smallest area in the cell string 21 for judgment of acceptance with defining a peeled area of less than 10% as an acceptance line. The hotspot resistance test was performed in accordance with IEC 61646 1st EDITION.
As the peeled area, a surface of the sample was photographed from the side of the substrate 2, the contrast of an obtained image was increased to obtain a monochrome image, and a percentage of the area accounted for by the white part in this image was calculated. Since a part that experienced peel-off of a film usually has a larger luminance, the percentage of the area of the white part obtained in the above-described manner corresponds to the percentage of the area of the part that experienced peel-off of a film (peeled area).

Table 2 shows a result obtained. Table 2 shows the results of the measurement of the area where peeling occurred for 54 types of samples having different outputs of the cell strings 21 or different RB currents. Here, the area where peeling occurred exceeded 10% in the samples indicated by dashes.

**Table 2**

| | | | | | | | | | |
|---|---|---|---|---|---|---|---|---|---|
| Output from entire sample (W) | 85 | 84 | 100 | 120 | 100 | 90 | 120 | 90 | 100 |
| Number of parallel division stages (number of cell strings) | 17 | 12 | 10 | 10 | 5 | 3 | 3 | 2 | 2 |
| Output from cell string→ RB current↓ | 5 W | 7 W | 10 W | 12 W | 20 W | 30 W | 40 W | 45 W | 50 W |
| 0.019 mA/cm² | 0.1% | 0.2% | 1.5% | 2.3% | 3.5% | 4.1% | 4.8% | 5.5% | 6.2% |
| 0.084 mA/cm² | 0.8% | 1.0% | 1.7% | 2.5% | 3.9% | 4.6 % | 5.1% | 5.8% | 6.5% |
| 0.31 mA/cm² | 0.9% | 1.5% | 2.1% | 4.5% | 5.1% | 6.5% | - | - | - |
| 2.06 mA/cm² | 1.0% | 1.7% | 2.6% | 4.8% | 5.8% | 7.2% | - | - | - |
| 2.29 mA/cm² | 0.7% | 1.0% | 1.7% | 2.6% | 4.1% | 4.8% | 5.3% | 5.8% | 6.4% |
| 6.44 mA/cm² | 0.1% | 0.1% | 1.2% | 2.3% | 3.7% | 4.1% | 4.5% | 5.2% | 5.8% |

Table 2 has revealed that the samples are unlikely to experience peel-off of a film in both the case where the magnitude of the RB current is very small (0.019 mA/cm²) and the case where the magnitude of the RB current is very large (6.44 mA/cm²), and the samples are likely to experience peel-off of a film in the case where the magnitude of the RB current is moderate (0.31 to 2.06 mA/cm²), even if the output from the cell string 21 is the same.

It has been also revealed that the peeled area can be held to 10% or less regardless of the value of the RB current, when the output from the cell string is 30 W or less.

### 6. Reverse overcurrent resistance test

Next, a reverse overcurrent resistance test was performed in the following manner.
First, samples having the same configuration as that of the thin-film solar cell module of the embodiment described above with reference to FIG. 1, FIG. 2, FIG. 3 were produced by using materials shown in Table 1. The number of series connection stages of each sample was 30.
Next, the reverse overcurrent resistance test was performed by examining whether or not the contact line 17 was damaged when an overcurrent was applied to the produced samples in a reverse direction (the reverse direction referred to means a direction opposite to a direction in which a current passes when the solar cell is in light, that is, it would be a forward direction in the case where the solar cell not in light is considered a diode).

According to the provisions of IEC 61730, the current to be applied here needs to be 1.35 times the anti-overcurrent specification value, and was set to 5.5 A at 70 V here.

Here, when a current is applied to one cell module under the above-described condition, it is apt to be considered that the current will be divided equally to be applied to each cell string connected in parallel. Actually, however, the current can be concentrated in a particular cell string, because the resistance value varies from string to string. On the assumption that this is the worst case situation, problems must be prevented from occurring even when 70 V × 5.5 A = 385 W is applied to one cell string. Therefore, a power of 70 V × 5.5 A = 385 W was applied to one cell string 21 to carry out the test.

Samples of 20 types that are different from one another in length L or width W of the cross-section of the contact line 17 were produced to carry out the test. It was judged by visual observation whether or not the contact line 17 was damaged. The contact line 17 was judged to have been damaged when there was discoloring or peel-off in the rear surface electrode 11 in a half oval shape along the contact line 21. Table 3 shows a result obtained.

**Table 3**

| Length L of cross-section of contact line (cm)→ Width W of cross-section of contact line↓ | 37.5 | 30 | 22.5 | 18 | 15 | 12.9 | 11.3 | 10 | 9 | 8.2 |
|---|---|---|---|---|---|---|---|---|---|---|
| 20 µm | ○ | ○ | ○ | ○ | × | × | × | × | × | × |
| 40 µm | ○ | ○ | ○ | ○ | ○ | ○ | ○ | ○ | ○ | × |

Table 3 has revealed that when the width W of the cross-section of the contact line 17 is 20 µm and 40 µm, damage to the contact line 17 can be prevented by setting the length L of the cross-section of the contact line 17 to 18 cm or more and 9 cm or more, respectively. In other words, it has been revealed that the cross-sectional area Sc of the contact line 17 should be 20 µm × 18 cm = 0.036 cm² or more, or 40 µm × 9 cm = 0.036 cm² or more.

Furthermore, it has been revealed that (power applied to cell string 21) / (area Sc of contact line 17) ≅ 10.7 kW/cm², because the power applied to the cell string 21 was 385 W, and therefore damage to the contact line 17 can be prevented when the power density applied to the contact line 21 is 10.7 kW/cm² or less.

### DESCRIPTION OF THE REFERENCE NUMERALS

- 1: Thin-film solar cell module
- 1a: Cell module
- 2: Substrate
- 3: Front surface electrode
- 5: First photoelectric conversion layer
- 7: Second photoelectric conversion layer
- 9: Third photoelectric conversion layer
- 11: Rear surface electrode
- 5a: P-type semiconductor layer
- 5b: Buffer layer
- 5c: I-type amorphous layer
- 5d: N-type semiconductor layer
- 7a: P-type semiconductor layer
- 7b: Buffer layer
- 7c: I-type amorphous layer
- 7d: N-type semiconductor layer
- 9a: P-type semiconductor layer
- 9b: I-type microcrystalline layer
- 9c: N-type semiconductor layer
- 13: Front surface electrode division line
- 17: Contact line
- 21: Cell string
- 23: Common electrode
- 25: Alignment dividing line
- 27: Solar cell
- 29: Rear surface electrode division line
- 31: Blocking diode
- 101: Film forming chamber
- 102: Cathode electrode
- 103: Anode electrode
- 105: Impedance matching circuit
- 106a: Power introducing line
- 106b: Power introducing line
- 107: Substrate
- 108: Power supply section
- 110: Gas intake section
- 116: Gas exhaust section
- 117: Pressure control valve
- 118: Gas
- 119: Gas exhaust outlet
- 150: Thin-film solar cell array
- 201: Substrate
- 202: Cell string
- 203: Solar cell
- 204: Common electrode
- 210: Thin-film solar cell module

## Claims

1. A thin-film solar cell module, comprising:
a substrate; and
a cell module that includes three or more cell strings, each of which has a constant width, and has a first common electrode and a second common electrode for electrically connecting the cell strings so that a current generated in each cell string can flow with respect to one another, wherein
each cell string comprises a plurality of solar cells having the same width as that of the cell string and being connected in series,
the cell strings are provided on the substrate so as to be aligned in a direction perpendicular to a direction in which the solar cells are connected in series,
each cell string comprises two electrodes, one of which is electrically connected to the first common electrode while the other is electrically connected to the second common electrode,
the solar cells each have a front surface electrode, a photoelectric conversion layer and a rear surface electrode stacked in this order,
each cell string comprises contact lines which electrically connect the front surface electrode of one of neighboring solar cells of the solar cells and the rear surface electrode of the other, the solar cells being included in the cell string, and have the same width as that of the cell string, and
at least one of the cell strings at the two ends of the three or more cell strings has a width greater than that of the other cell strings.

2. The thin-film solar cell module according to claim 1, wherein the cell strings at the two ends of the three or more cell strings have a width greater than that of the other cell strings.

3. The thin-film solar cell module according to claim 1 or 2, wherein the closer the cell string is to an end of the cell modules in the direction perpendicular to the direction in which the solar cells are connected in series, the greater the width of the cell string is.

4. The thin-film solar cell module according to any one of claims 1 to 3, wherein the cell string having the greatest width has a width three times or less greater than the width of the cell string having the smallest width.

5. The thin-film solar cell module according to any one of claims 1 to 4, wherein the cell strings have the same length in the direction in which the solar cells are connected in series.

6. The thin-film solar cell module according to any one of claims 1 to 5, wherein the contact lines have a cross sectional area Sc of L × W where W is from 40 µm to 200 µm and L is from 5 cm to 50 cm.

7. The thin-film solar cell module according to any one of claims 1 to 6, wherein the cell strings have an output of 30 W or less under a condition of light source: xenon lamp, irradiance: 100 mW/cm², AM: 1.5, and temperature: 25°C.

8. The thin-film solar cell module according to any one of claims 1 to 7, wherein at least one of the cell strings at the two ends of the three or more cell strings satisfies that (P - Ps)/Sc is 10.7 kW/cm² or less where an output from the cell module is P (W) and an output from the cell string is Ps (W), and the cross sectional area of the contact lines included in the cell string is Sc (cm²) under a condition of light source: xenon lamp, irradiance: 100 mW/cm², AM: 1.5, and temperature: 25°C.

9. The thin-film solar cell module according to any one of claims 1 to 8, wherein the cell strings satisfy that (P - Ps)/Sc is 10.7 kW/cm² or less when an output from the cell module is P (W) and an output from the cell string is Ps (W), and the cross sectional area of the contact lines included in the cell string is Sc (cm²) under a condition of light source: xenon lamp, irradiance: 100 mW/cm², AM: 1.5, and temperature: 25°C.

10. The thin-film solar cell module according to any one of claims 1 to 9, wherein the front surface electrode is made of a transparent conductive film containing an oxide that includes Sn and the rear surface electrode has a multilayer structure of a transparent conductive film and a metal film.

11. The thin-film solar cell module according to any one of claims 1 to 10, wherein the cell module has an output of 90 W or higher and 385 W or less under a condition of light source: xenon lamp, irradiance: 100 mW/cm², AM: 1.5, and temperature: 25°C.

12. A thin-film solar cell array, wherein the thin-film solar cell module according to any one of claims 1 to 11 is installed in such a manner that a light receiving surface inclines relative to a horizontal plane, and
the cell string having the greatest width is located in a lower portion.
